# EUROPEAN PATENT APPLICATION

(11) **EP 4 696 493 A1**
(43) Date of publication of application: **18.02.2026**
(21) Application number: 24194867.8
(22) Date of filing: 16.08.2024
(51) Int. Cl.: B32B 5/02, B32B 5/26, B32B 27/12, B32B 27/40, H05K 1/00

(54) **TEXTILE CONNECTOR**

(71) Applicant: Universiteit Gent, 9000 Gent (BE); Imec VZW, 3001 Leuven (BE)
(72) Inventor: VESKE-LEPP, Paula, 9052 Gent (BE)
(74) Representative: Ipsilon Belgium

(57) **Abstract**

A method for manufacturing a textile connector patch (2) for a textile connector, the method comprising: providing a first outer patch (210) comprising a first textile patch (211); providing a conductive patch (241) on the first outer patch; providing a thermoplastic patch (250) having a through-hole (245) onto the conductive patch; providing a connector wire (261) between the conductive patch and the thermoplastic patch such that the connector wire is exposed by the through-hole; laminating (500) the first outer patch, the conductive patch and the thermoplastic patch together, thereby forming a laminated stack (270) that clamps the connector wire; providing (501) a conductive resin (260) within the through-hole; providing (502) a second outer patch (220) comprising a second textile patch (221) onto the thermoplastic patch; and laminating (503) the provided patches (210, 241, 250, 220) together to obtain the textile connector patch; wherein, by the laminating, the conductive resin is deformed to provide a permanent connection between the connector wire and the conductive patch.

## Description

### Technical field

The present invention generally relates to method for manufacturing a textile connector patch for a textile connector, a method for manufacturing a textile connector, a textile connector patch for a textile connector and a textile connector.

### Background

Smart textiles are fabrics with integrated electronics. Smart textile systems may provide an electrical contact with a body of a human or animal via clothing, e.g. for sensoring or applying a stimulus.

Some challenges of smart textile systems include the following. A stable conductive path needs to be provided to a point or region of contact with the body. This may include a need to keep the electronics in place during measurements. Further, the fabric may also be subject to wear and tear, e.g. due to washing. The integrated electronics need to be able to retain their functioning under such circumstances. An efficient manufacturing process is also desirable.

In a smart textile system, a sensor may be applied to the skin surface to capture a signal. In order to read out and/or further process such a signal, the signal needs to be accessible by a processing unit. Such a processing unit is typically located at a distance of the sensor, e.g. on the outside of the textile system. To this end, a textile connector can provide a conductive path to the sensor. Such a textile connector then connects to the sensor on one end and to the processing unit on the other end. The textile connector generally comprises a patch of material having a conductive fastener that can directly attach to the sensor. Further, the textile connector comprises a conductive wire that is connected to the conductive fastener on one end. The conductive wire further extends outwardly from the patch on the other end, to form a conductive extension. The conductive extension can as such serve as an extension cord between the sensor and the processing unit.

There are specific requirements for a textile connector to function properly in smart textiles. Firstly, the textile connector is to provide a stable conductive path. Further, it needs to be flexible to adapt to the changing shape of the textile as it is worn by a person or an animal. In addition, the fabric to which it is attached may suffer from wear and tear and can be washed repeatedly. Therefore, the textile connector needs to retain its functionality over frequent rubbing, abrasion and/or washing cycles and the like. In addition, manufacturing of the textile connector should be efficient and scalable.

### Summary

The present disclosure aims to alleviate at least one of the above mentioned obstacles.

According to some aspects, there is provided the subject matter of the independent claims. Some further aspects are defined in the dependent claims.

According to a first aspect, a method for manufacturing a textile connector patch for a textile connector is provided. The method comprises:
- providing a first outer patch comprising a first textile patch;
- providing a conductive patch on the first outer patch;
- providing a thermoplastic patch having a through-hole onto the conductive patch;
- providing a connector wire between the conductive patch and the thermoplastic patch such that the connector wire is exposed by the through-hole;
- laminating the first outer patch, the conductive patch and the thermoplastic patch together, thereby forming a laminated stack that clamps the connector wire;
- providing a conductive resin within the through-hole;
- providing a second outer patch comprising a second textile patch onto the thermoplastic patch; and
- laminating the provided patches together to obtain the textile connector patch; wherein, by the laminating, the conductive resin is deformed to provide a permanent connection between the connector wire and the conductive patch.

The textile connector patch resulting from the manufacturing method comprises outer patches, i.e. the first and second outer patches, and inner patches, i.e. the conductive patch and the thermoplastic patch. The textile connector patch further comprises the conductive resin between the outer patches.

In a first phase of the manufacturing method, the laminated stack is provided that forms the base of the textile connector patch. Thereto, the first outer patch, the conductive patch and the thermoplastic patch are layered. The connector wire is held between the conductive patch and the thermoplastic patch. During providing of the connector wire, the through-hole allows inspection for accurate positioning of the connector wire. As such, the connector wire can be positioned over an area on the conductive patch that is defined by the through-hole. After the stack is constructed, it is laminated in a first lamination step resulting in the laminated stack. This provides a permanent binding of the first outer patch, the conductive patch, and the thermoplastic patch together and clamping the connector wire.

In a second phase of the manufacturing method, the laminated stack is further heaped to form a complete textile connector stack. To achieve this, the resin is placed within the through-hole and the second outer patch is provided onto the thermoplastic patch as a lid. After all the components of the textile connector patch are provided, the second lamination step permanently binds them together. As such, the textile connector patch is obtained with the connector wire sticking out.

The resin is a mass of deformable, solid material. Upon activation, a deformation phase is initiated during which the resin can be reshaped, e.g. by applying pressure. Activation may, for example, be induced by applying heat or by mixing the resin with an activating chemical compound. During the second lamination step, the resin is activated by the lamination heat and/or pressing. The resin is reshaped due to the pressing forces of laminating plates. After the deformation phase, a curing phase occurs during which the resin becomes solid again. After curing, the resin is stiff and keeps its shape. The conductive resin is conductive at least after curing. Optionally, the resin is already conductive before performing the manufacturing method.

Before deformation of the resin, the through-hole keeps the resin within the boundaries of the through-hole for an optimal positioning for lamination. Upon lamination, the resin may deform and be pressed between the conductive patch and the second outer patch. As a result of the lamination, the resin material may also creep between patches, e.g. between the thermoplastic patch and the conductive patch. This may occur due to the pressing and/or heating up during lamination.

The finished textile connector patch provides a conductive path formed by the connector wire, the conductive resin and the conductive patch. The connection between the connector wire and the conductive patch is provided by positioning the wire onto the conductive patch. Upon lamination, a portion of the connector wire not exposed by the through-hole is pressed between the conductive patch and the thermoplastic patch. This creates a good conductive connection between the connector wire and the conductive patch. Further, upon deformation the conductive resin surrounds a portion of the wire exposed by the through-hole and provides a contact surface with the conductive patch. As a result, the connection between the connector wire and the conductive patch is further improved. Additionally, the resin may partially creep between the conductive patch and the thermoplastic patch, thereby further contributing to a good connection.

The through-hole of the thermoplastic patch fulfils several roles. Firstly, the through-hole creates a confined region for the resin to expand in a controlled manner along the exposed portion of the connector wire. This provides a contact surface between the resin and the conductive patch that captures the exposed portion of the connector wire. Secondly, the through-hole keeps the resin in place for the final laminating step. Thirdly, it enables a favourable positioning of the connector wire by allowing monitoring, e.g. visual or tactile, of the wire during placement. These technical effects add to the advantage of providing a good and stable connection between the connector wire and the conductive patch. Thereby, signal integrity can be guaranteed during use of the textile connector patch. In addition, the through-hole allows for an efficient manner of manufacturing with only two laminating steps. The manufacturing method requires no other tools than lamination equipment. Additionally, the method allows for a fast manufacturing. If lamination plates are used that are large enough to laminate the patches at once, the manufacturing method can be performed in only two lamination steps.

An additional advantage of the method is that by clamping the connector wire between patches of the textile connector patch, the conductive connector wire is already provided attached to the textile connector patch.

A further advantage, resulting from providing the first and second outer patches, is that the inside of the textile connector patch is protected. The inside includes the inner patches, the resin and the connector wire end. The textile outer patches shield the inner patches from wear and tear resulting from washing, since textile material has suitable properties thereto. As such, the inner patches are protected against phenomena such as delamination. Further, the use of textile and thermoplastic materials makes the resulting textile connector patch both soft as well as flexible, making it well-suited for smart textiles.

According to further example embodiments, the first outer patch further comprises a first thermoplastic patch laminated to the first textile patch. According to further example embodiments, the first outer patch is positioned such that the first textile patch faces a first outer side of the textile connector patch.

According to further example embodiments, the second outer patch further comprises a second thermoplastic patch laminated to the second textile patch. According to further example embodiments, the second outer patch is positioned such that the second textile patch faces a second outer side of the textile connector patch.

By providing either or both of the outer patches with a thermoplastic patch, the textile connector patch becomes more firm. By keeping the textile patches on the outside of the textile connector, the textile outer patches also shield the first and/or second thermoplastic patches.

According to further example embodiments, the method further comprises providing a further thermoplastic patch between the conductive patch and the first outer patch.

The further thermoplastic patch is included in the stack before performing the first lamination step. The further thermoplastic patch further increases the firmness of the textile connector patch.

According to further example embodiments, the method further comprises laminating the further thermoplastic patch onto the conductive patch.

The further thermoplastic patch and the conductive patch may be laminated together separately before assembling the stack, or may be laminated together during the first lamination step.

According to further example embodiments, the method further comprises providing a second conductive patch between the laminated stack and the second outer patch; and, by the laminating, the permanent connection is further provided with the second conductive patch.

By providing the second conductive patch, the resin material and the connector wire are pushed together within a region provided by the through-hole during the second lamination step. As such, the conductive path further includes the second conductive patch. This further improves the conductive connection of the textile connector patch with the connector wire.

According to further example embodiments, the method further comprises activating the conductive resin to allow deformation of the conductive resin during laminating.

The conductive resin may, for example, be activated by adding a chemical compound. The curing may happen automatically over time due to the properties of the resin, or may be induced, e.g. by mixing with a curing chemical compound.

According to further example embodiments, the conductive patch and the thermoplastic patch have equal area dimensions, first area dimensions, and the first and second outer patches have equal area dimensions, second area dimensions.

The area dimensions are defined in a top/bottom view of the textile connector patch. By providing the inner patches with equal area dimensions, the structure of the textile connector patch is stable. By providing the outer patches with equal area dimensions, the inner patches are shielded equally on both outer sides of the textile connector patch.

According to further example embodiments, the second area dimensions are larger than the first area dimensions such that the permanent connection is contained within the first and second outer patches.

By providing the second area dimensions larger than the first area dimensions, the textile patches overhang the inner patches. As a result, an improved shielding is provided.

According to further example embodiments, the connector wire extends outwardly from the textile connector patch, thereby defining a clamped portion and an elongated portion of the connector wire.

The clamped portion is the portion of the connector wire within the textile connector patch. The elongated portion is the portion of the connector wire outside of the textile connector patch. The elongated portion functions as an extension cord from the textile connector patch to a smart textile device, such as a sensor, to which the textile connector patch is attached.

According to further example embodiments, the elongated portion is provided with a protective sheath.

By providing the protective sheath, the elongated portion is shielded from the environment. As a result, less electrical disturbances may influence the connector wire, thereby providing a better conductive path to the textile connector patch.

According to further example embodiments, the protective sheath is made of textile material.

The protective sheath may, for example, be shaped as a strip onto which the connector wire is attached. As another example, the protective sheath may be shaped enclosing the connector wire. For example, the connector wire may be placed between two textile strips and the textile strips may be sown together. By providing the sheath as a textile layer, the connector wire has an increased resistance to wear and tear, in particular due to repeated washing.

According to further example embodiments, the protective sheath is an electrically isolating material.

For example, a cable may be formed. The electrical shielding further prevents electrical disturbances from affecting a signal on the connector wire.

According to a second aspect, there is provided a method for manufacturing a textile connector. The method comprises performing the steps of the method according to the first aspect to manufacture a textile connector patch. The method further comprises piercing a snap fastener through the textile connector patch, thereby providing a conductive path through the textile connector patch via the permanent connection.

The snap fastener is at least partially provided through the through-hole of the thermoplastic layer. The snap fastener comprises two components that interlock with each other upon being pushed together. A component is provided on both the first and second outer textile patch and pressed together through the inner patches.

The method according to the second aspect may provide one or more of the above-mentioned advantages. Additionally, the snap fastener is conductive and provides a connection point for connecting with a smart textile device such as a sensor. The snap fastener extends the conductive path provided by the conductive patch, the conductive resin and the connector wire. In addition, snap fasteners are suited for fixating textile fabrics and may thus provide a secure fastening means for the textile connector patch having textile outer patches.

Further, a good connection between the snap fastener and the connector wire is ensured due to the conductive resin in the through-hole. Because the resin is spread out at least within the through-hole, a conductive region is created where the snap fastener can be pierced through. Without the resin, the snap fastener would need to be carefully positioned over a location of the connector wire before piercing through to guarantee a good connection. This may be difficult or even impossible to achieve, since an exact location of the wire may no longer be visible at the moment of piercing. Piercing the snap fastener through a thin wire requires a much higher precision than piercing through the region provided by the resin. As such, the method is robust to positioning variations of the snap fastener with respect to the textile connector patch. As a result, the method may be quickly performed and with a low production fault rate.

According to a third aspect, a textile connector patch for a textile connector is provided. The textile connector patch comprises:
- a first outer patch comprising a first textile patch;
- a conductive patch on the first outer patch;
- a thermoplastic patch having a through-hole, the thermoplastic patch on the conductive patch;
- a connector wire between the conductive patch and the thermoplastic patch and partially located within the through-hole;
- a conductive resin cured throughout the through-hole, the conductive resin providing a permanent connection between the connector wire and the conductive patch; and
- a second outer patch comprising a second textile patch,
wherein the patches are laminated together to form the textile connector patch.

The textile connector patch according to the third aspect may provide one or more of the above-mentioned advantages. The textile connector patch according to the third aspect may be provided by performing the method according to the first aspect.

According to a fourth aspect, a textile connector is provided. The textile connector comprises the textile connector patch according to the third aspect and a snap fastener through the textile connector patch, the snap fastener providing a conductive patch through the conductive resin.

The textile connector according to the fourth aspect may provide one or more of the above-mentioned advantages. The textile connector according to the fourth aspect may be provided by performing the method according to the second aspect.

### Brief Description of the Drawings

Fig. 1 illustrates a textile connector;
Fig. 2 illustrates a textile connector patch according to example embodiments;
Fig. 3 illustrates a textile connector according to example embodiments;
Fig. 4 illustrates a textile connector according to example embodiments and a textile connector patch according to example embodiments;
Fig. 5 illustrates a method of manufacturing a textile connector patch according to example embodiments;
Fig. 6 illustrates a method of manufacturing a textile connector according to example embodiments;
Fig. 7 illustrates a method of manufacturing a textile connector according to example embodiments; and
Fig. 8 illustrates a method of manufacturing a textile connector according to example embodiments.

### Detailed Description of Embodiment(s)

The present disclosure relates to the field of wearable electronics, also referred to as smart textiles, i.e. electronics embedded into clothing for humans or animals. For example, a smart textile may be a sweater or a jacket comprising an electronic sensor.

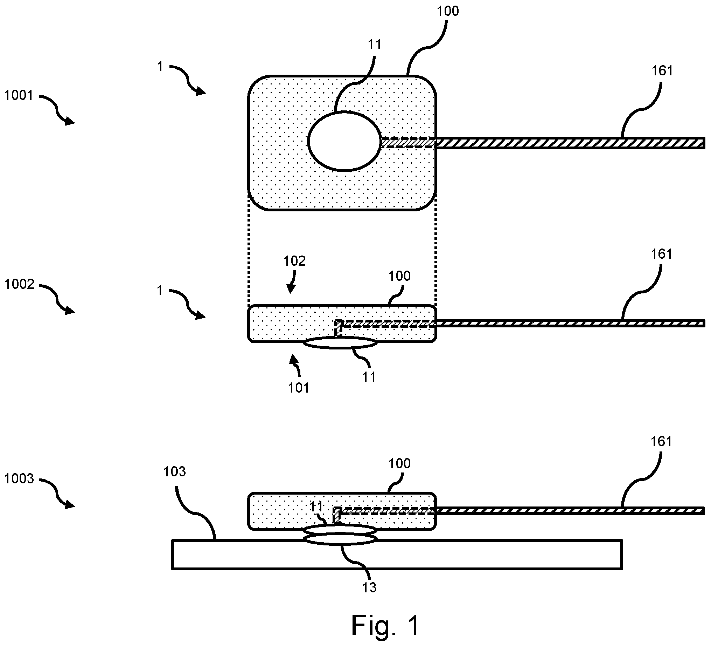

Figure 1 shows an example of a textile connector 1. Subfigure 1001 shows a bottom view of the textile connector 1. The textile connector 1 comprises a main structure 100, a conductive connector wire 161 and a conductive connection region 11 for making electrical contact. The connector wire 161 is connected to the connection region 11 and an end of the connector wire 161 is held by the main structure 100. Subfigure 1002 shows a side view of the textile connector 1. The textile connector 1 has a first outer side 101 and a second outer side 102. The connector wire 161 is configured to be connected to a processing unit (not shown) on one end and to a sensor 103 on the other end as illustrated in subfigure 1003. Such a sensor 103 comprises a connection region 13 for connecting with the connection region 11. Signals sensed by the sensor 103 are provided at the connection region 13. The connector wire 161 is configured to be connected to the processing unit on one end and to the structure 100 on the other end. The structure 100 is configured to provide a conductive path between the connector wire 161 and the sensor 103.

Textile connectors are configured to connect an electronic smart textile device 103 to a processing unit, as illustrated in Figure 1. Such a smart textile device 103 interacts with the body during use and may, for example, be a smart textile sensor 103. It is noted that the smart textile device 103 could also be a smart textile actuator, i.e. generating a signal, e.g. electrical or mechanical, to be applied to the body.

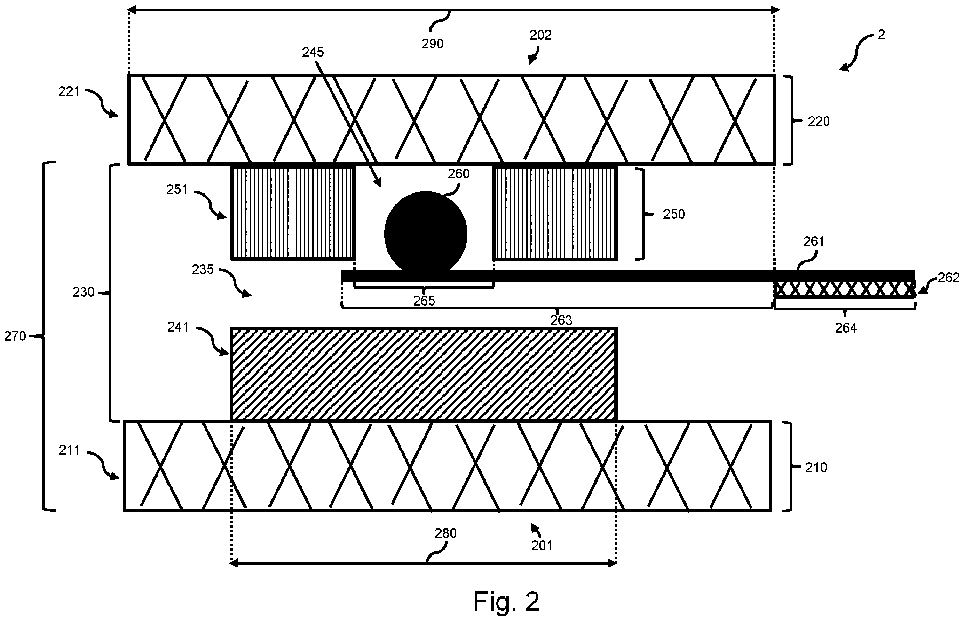

Figure 2 shows a textile connector patch 2 according to example embodiments. Figure 2 shows the components of the textile connector patch 2 prior to being laminated together, for a clear depiction of each of the functional components.

The textile connector patch 2 comprises several layered patches 210, 220, 241. A patch is a flat piece of material, e.g. resulting from cutting a sheet of material. A height of a patch is significantly smaller than surface dimensions, i.e. width and length of the patch, for example at least 5 or 10 times smaller. A patch may, for example, have a square, rectangular, triangular, circular or other shape. The patches 210, 220, 241, 250 of the textile connector patch may have the same shape, e.g. square or circular. Optionally, the patches 210, 220, 241, 250 of the textile connector patch 2 may even have the same dimensions.

The textile connector patch 2 comprises a first outer patch 210 comprising at least a first textile patch 211 on a first outer side 201. On the opposite end, the textile connector patch 2 comprises at least a second outer patch 220 comprising a second textile patch 221 on a second outer side 202. The textile patches 211, 221 are made of fabric, e.g. knitted or woven yarn. This makes the textile connector patch 2 washable and resistant to wear and tear. The first and second outer patches 210, 220 may have an equal width 290 for a matching fit of the closing layers of the textile connector patch 2. This may provide a proper shielding of the patches between the outer patches 210, 220.

The textile connector patch 2 further comprises a conductive patch on the first outer patch 210. The conductive patch may be a single conductive patch 241. Alternatively, the conductive patch may comprise two or more conductive patches. The conductive patch 241 is made of a conductive material and may, for example, comprise one or more patches comprising conductive textile. The textile connector patch 2 further comprises a thermoplastic patch 250 on the conductive patch 241. The thermoplastic patch 250 comprises a thermoplastic material, i.e. a material that becomes deformable when heated. Such a thermoplastic material may, for example, be a thermoplastic polyurethane, TPU. The thermoplastic patch 250 may comprise a single thermoplastic patch 251, or may comprise multiple thermoplastic patches. The conductive patch 241 and the thermoplastic patch 250 may have an equal width 280.

Further, the textile connector patch 2 comprises a conductive connector wire 261 for connecting to a processing unit (not shown). The connector wire 261 is located between the conductive patch 241 and the thermoplastic patch 250. The connector wire may, for example, be a copper wire, a single conductive yarn, or a bundle of conductive yarns. After lamination, the connector wire 261 is clamped between the conductive patch 241 and the thermoplastic patch 250.

The thermoplastic patch 250 has a through-hole 245. The through-hole 245 may, for example, have a circular or a rectangular cross-section. The connector wire 261 is partially exposed by an opening of the through-hole 245, thereby defining an exposed portion 265 of the connector wire 261. The textile connector patch 2 further comprises a conductive resin 260 within the through-hole 245. After manufacturing, the conductive resin 260 is spread throughout the through-hole 245. As a result, the conductive resin 260 provides a connective adhesive between the connector wire 261 and the conductive patch 241. In other words, the conductive resin facilitates a good permanent conductive connection between the connector wire 261 and the conductive patch 241. The through-hole 245 keeps most of the resin 260 in place during manufacturing and in particular keeps the resin 260 confined during expansion. The patches 210, 241, 250, 220 are laminated together to form the textile connector patch 2 as one cohesive structure.

The textile patches 210, 220 are outer patches and the conductive patch 241 and the thermoplastic patch 250 are inner patches and together form inner patch 230. The outer textile patches 210, 220 provide shielding of the inner patch 330. The width 290 may be larger than the width 280 such that the inner patch 330 is contained within the first and second outer patches 210, 220. This further increases the shielding of the patches 241, 250.

During manufacturing of the textile connector patch 2, a stack 270 is formed comprising the first outer patch 210, the conductive patch 241 and the thermoplastic patch 250 with the connector wire 261 clamped between patches 241 and 250. Upon laminating the stack 270 into a laminated stack, region 235 disappears and the patches 241, 250 are pressed together. The region 235 merely serves illustrative purposes to clearly show the different components of the textile connector patch 2.

The connector wire 261 extends outwardly from the textile connector patch 2 and has a clamped portion 263 and an elongated portion 264. The portion 263 becomes clamped and the elongated portion 264 sticks out of the textile electrode patch 2 upon laminating of the stack 270 during manufacturing. The elongated portion 264 may be provided with a protective sheath 262. The protective sheath 262 may be a strip of textile material onto which the elongated portion 264 is attached.

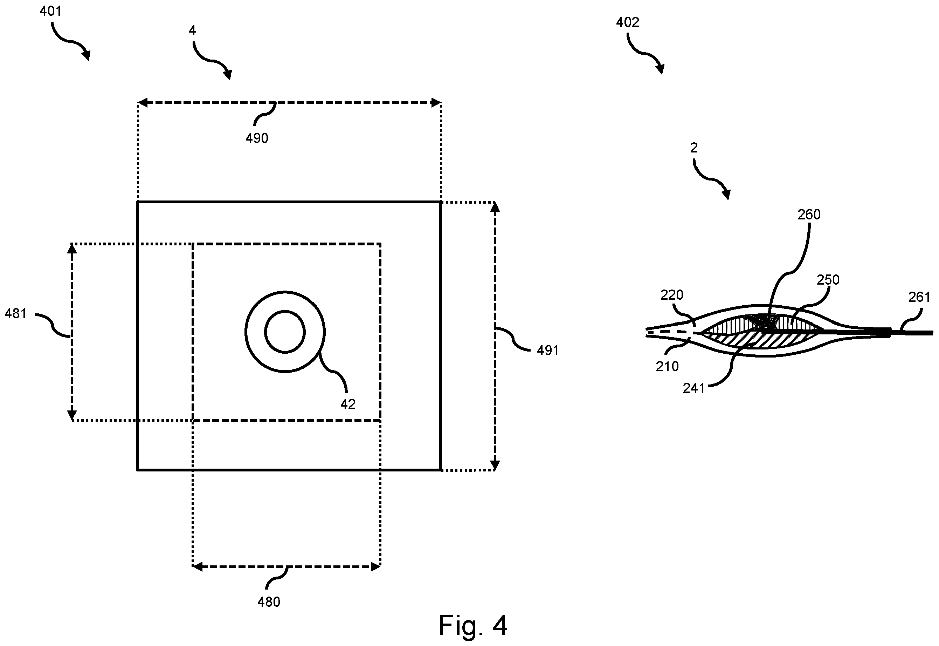

Subfigure 402 of Figure 4 shows the textile connector patch 2 of Figure 2 after lamination. Lamination includes heating up the textile connector patch 2 and pressing it together planarly between laminating plates. As shown in subfigure 402, when the width 290 is larger than the width 280, the inner patches 241, 250 are enclosed within the first and second outer patches 210, 220.

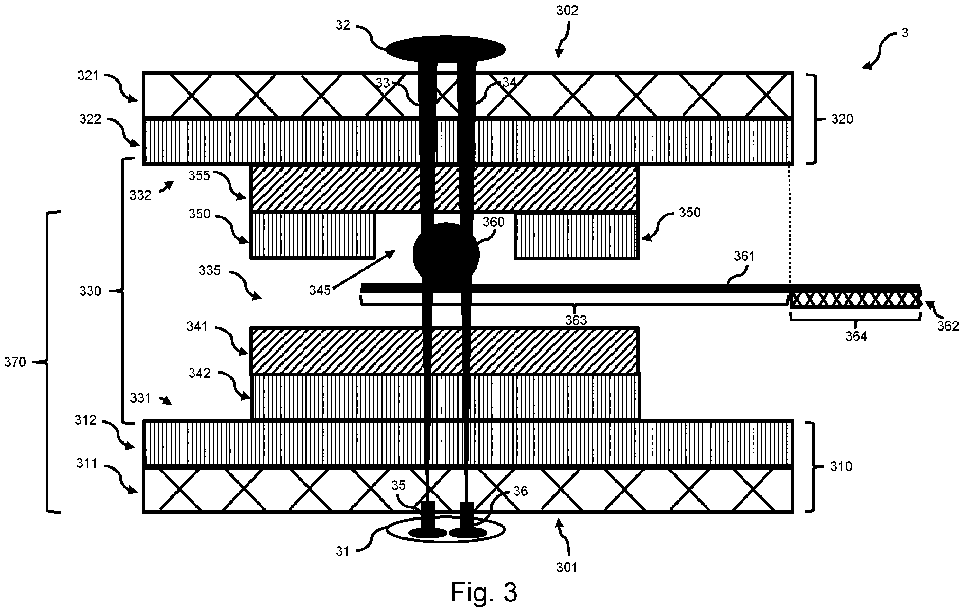

Figure 3 shows a textile connector 3 according to example embodiments. Figure 3 shows the components of the textile connector 3 prior to being laminated together, for a clear depiction of the structure.

Similar to the textile connector patch 2 in Figure 2, the textile connector 3 comprises: a first outer patch 310 at a first outer side 301; a second outer patch 320 at a second outer side 302; a conductive patch 341; a thermoplastic patch 350 comprising a through-hole 345; a conductive resin 360 within the through-hole 345; a connector wire 361 having a clamped portion 363 and an elongated portion 364 with a protective sheath 362. The first outer patch 310, the conductive patch 341 and the thermoplastic patch 350 form a stack 370. Upon laminating the stack 370 to obtain a laminated stack, region 335 disappears as the patches 341, 350 are pressed together, thereby clamping the portion 363. Similar to region 235 in Figure 2, empty region 335 is provided to clearly illustrate the stacking of the patches, the conductive resin 360 and the connector wire 361.

The outer patches 310, 320 each further comprise a first and second textile patch 311, 321 respectively. The textile patches 311, 321 face the outer sides 301, 302 of the textile connector 3 respectively. The outer patches 310, 320 each further comprise a first and second thermoplastic patch 312, 322 respectively. The thermoplastic patches 312, 322 are made of a thermoplastic material. Such thermoplastic patches 312, 322 may be provided to make the textile connector patch more firm while retaining its flexibility. The thermoplastic patches 312, 322 are provided at respective inner sides 331, 332 of the outer patches 310, 320. The outer patches 310, 320 may be pre-laminated patches, wherein the textile patches 311, 321 and the thermoplastic patches 312, 322 have been laminated together before the assembly of the textile connector 3.

The conductive patch 341 may be knitted or woven from conductive yarn or may be made of another conductive material. Optionally, the conductive patch 341 may be made of a combination of a non-conductive and a conductive material. A further thermoplastic patch 342, comprising a thermoplastic material, may be provided laminated onto the conductive patch 341. As a result, the firmness of the textile connector patch is further increased without compromising its flexibility. Optionally, the patches 341, 342 are pre-laminated, i.e. laminated together before assembly of the textile connector 3.

The textile connector 3 further comprises a second conductive patch 355 between the laminated stack 370 and the second outer patch 320. The second conductive patch 355 may be knitted or woven from conductive yarn or may comprise another conductive material. The second conductive patch 355 may be identical to the conductive patch 341, e.g. in size and/or material. Alternatively, the second conductive patch 355 is made of a material different from the material of the conductive patch 341. The permanent connection between the connector wire 361, the conductive resin 360 and the conductive patch 341 is further provided with the second conductive patch 355. As such, the second conductive patch 355 further contributes to a reliable conductive connection within the textile connector 3. The conductive patch 341, the further thermoplastic patch 342, the thermoplastic patch 350 and the second conductive patch 355 together form an inner patch 330, contrarily to outer patches 310, 320. The inner patch 330 may be smaller than the outer patches 310, 320. Alternatively, the second conductive patch 355 and/or the further thermoplastic patch 342 may have the same dimensions as the outer patches 310, 320. In that case, the patches 355, 342 are not part of the inner patch 330 and the inner patch 330 is only formed by the thermoplastic patch 350 and the conductive patch 341.

Optionally, another thermoplastic patch may be provided between the second conductive patch 355 and the second outer patch 320. This further adds to the firmness of the textile connector 3, thereby providing a more stable conductive path.

A snap fastener 31, 32 may be pierced through the textile connector patch, thereby providing a textile connector 3. The snap fastener has two components 31, 32 that interlock with each other upon being pushed together. A first component 32 may, for example, be a disk having two or more protuberances 33, 34 extruding from the disk surface. The second component 31 may comprise two or more corresponding receiving portions 35, 36 for receiving ends of the protuberances 33, 34 respectively. The components 31, 32 are respectively provided on the first and second outer textile patch 310, 320 and pressed together, thereby piercing through the outer patches 310, 320 and the inner patch 330.

The snap fastener 31, 32 is at least partially pierced through the through-hole 345 of the thermoplastic layer 350 during manufacturing to make contact with the conductive resin 360. Either of the two components 31, 32 of the snap fastener can serve as a connection point to a smart textile device 103. At least one of the components 31, 32 is made of a conductive material, e.g. a metal. In Figure 3, optionally only component 32 may be conductive in which case only component 32 provides a connection point for a smart textile device.

By providing the snap fastener 31, 32, a conductive path is provided through the textile connector patch. The permanent connection is then formed by the conductive patches 341, 355, the connector wire 361, the conductive resin 360 and the snap fastener 31, 32. As a result of the guaranteed positioning of the connector wire 361 within the through-hole 345, a good connection through the textile connector patch is provided. This may even be the case if only very few or even no conductive resin 360 is provided within the through-hole 345, e.g. due to an error during manufacturing. Additionally, if the snap fastener 32, 33 is not ideally positioned, i.e. off-centre, the conductive resin 360 helps to maintain a good connection thanks to the expanded contact region it provides. As a result, the textile connector 3 is robust to manufacturing errors.

The textile connector 3 is washable. It may pertain its functionality after washing it at least up to 25 times at 60 degrees Celsius, e.g. according to the International Organisation for Standardisation, ISO, 6330-2012 standard.

Figure 4 shows subfigure 401 depicting a top view of a textile connector 4 according to example embodiments. The textile connector 4 comprises rectangular patches. The textile connector 4 has outer patches having a width 490 and a length 491. The width 490 and length 491 are the surface dimensions of the outer patches, also referred to as second area dimensions. The textile connector 4 further has an inner patch having a width 480 and a length 481. The width 480 and length 481 are the surface dimensions of the inner patch, e.g. a conductive patch and a thermoplastic patch of textile connector 4. The width 480 and length 481 are also referred to as the first area dimensions. The textile connector 4 further comprises a fastener 42 applied around a centre of the textile connector patch. In the textile connector 4, the second area dimensions are larger than the first area dimensions such that the permanent connection is contained within the first and second outer patches.

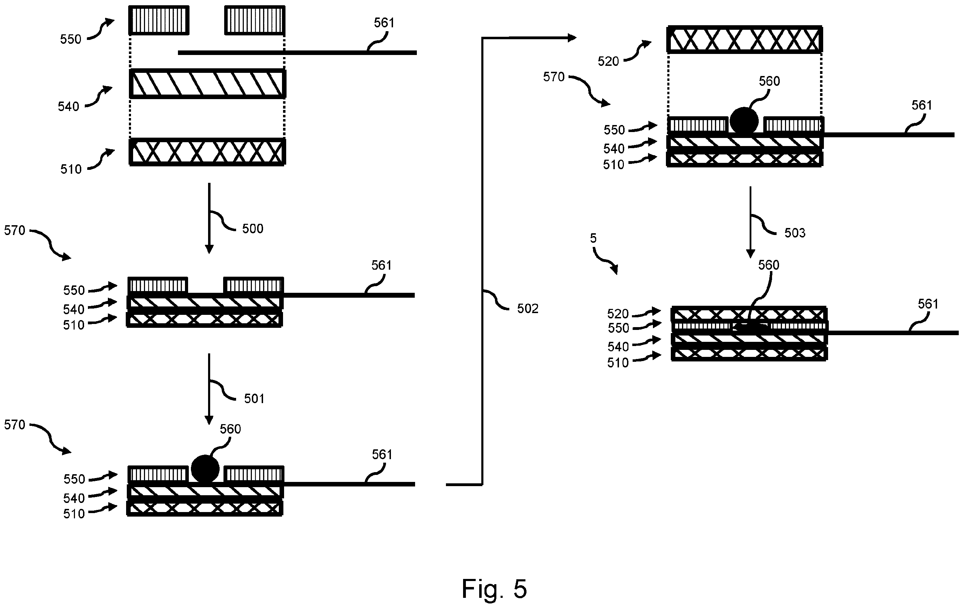

Figure 5 shows a method for manufacturing a textile connector patch 5 for a textile connector according to example embodiments.

A first outer patch 510 is provided as a base. Further, a conductive patch 540 is provided on the first outer patch 510 and a thermoplastic patch 550, having a through-hole, on the conductive patch 540. A connector wire 561 is provided between the conductive patch 540 and the thermoplastic patch 550 such that the connector wire 561 is exposed by the through-hole. In other words, the connector wire 561 is positioned such that it is at least partly provided on a region on the conductive patch 540 that is exposed by the through-hole. During the positioning, visual inspection, e.g. by a person or by a computational system equipped with a camera, can be done via the through-hole to monitor a positioning of the connector wire 561. If the connector wire 561 has an electrically insulating cover, this is removed over the portion that is to be clamped before performing lamination 500 to provide a electrical good connection within the textile connector patch 5. This may, for example, be done using a wire stripping tool or a laser, e.g. a CO₂ laser.

After layering the first outer patch 510, the conductive patch 540, the connector wire 561 and the thermoplastic patch, they are laminated together in step 500. By the laminating 500, a laminated stack 570 is formed that clamps the connector wire 561, thereby defining a clamped portion and an elongated portion of the wire 561.

In step 501, a conductive resin 560 is provided on the laminated stack 570 within the through-hole.

In step 502, a second outer patch 520 is provided onto the thermoplastic patch 550. Optionally, the conductive resin 560 may be additionally activated for curing, e.g. by adding a curing chemical component. The conductive resin 560 may automatically become deformable due to the heat and/or pressure provided during the laminating.

Upon finishing the connector patch stack in step 502, the patches are laminated together in step 503. By the laminating 503, the conductive resin 560 is deformed to provide a permanent connection between the connector wire 561 and the conductive patch.

In a further step (not shown), a snap fastener may be applied to the textile connector patch 5 to provide a textile connector. As a final processing step (not shown), the textile connector patch 5 may be cut into a desired shape.

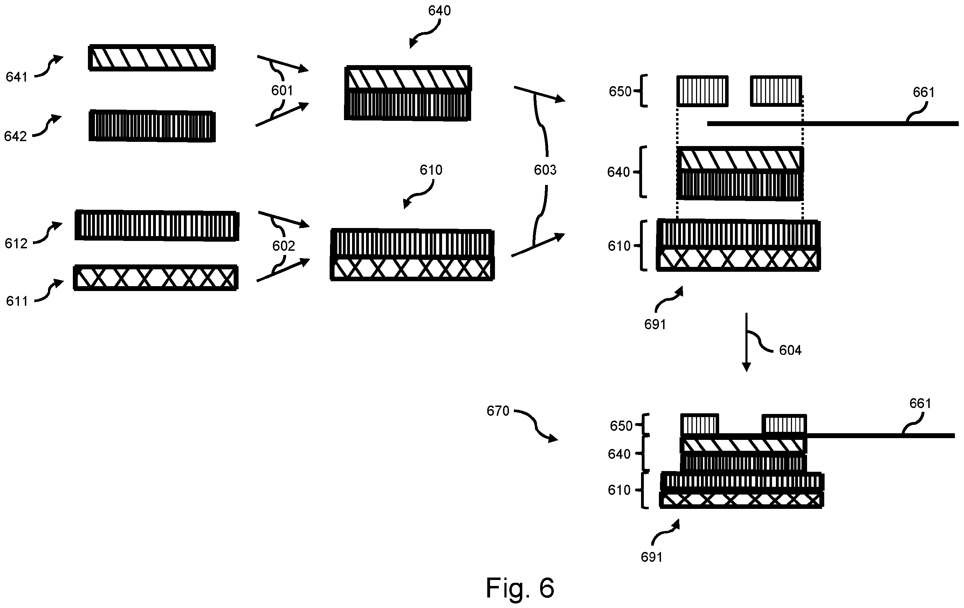

Figures 6-8 show a method for manufacturing a textile connector 6 according to example embodiments.

Figure 6 shows providing 603 a stack for the textile connector 6. The stack is formed by providing a first outer patch 610, a patch 640, a thermoplastic patch 650 and a connector wire 661 between the patch 640 and the thermoplastic patch 650.

The first outer patch 610 comprises a first textile patch 611 and a first thermoplastic patch 612 laminated to the first textile patch 611. The patches 611, 612 may be laminated 602 together during the manufacturing method, or may be pre-laminated.

Further, the patch 640 comprises a conductive patch 641 and a further thermoplastic patch 642. The further thermoplastic patch 642 is laminated 601 onto the conductive patch 641. This laminating step 601 may be performed as part of the method, or may be done beforehand.

To form the stack, the patch 640 is placed on the first outer patch 610 in step 603. Thereto, the conductive patch 641 is provided on the first outer patch 610. The further thermoplastic patch 642, already attached to the conductive patch 641, is placed against the first thermoplastic patch 612. As such, the further thermoplastic patch 642 is provided between the conductive patch 641 and the first outer patch 610. The first outer patch 610 is positioned such that the first textile patch 611 faces a first outer side 691 of the textile connector 6.

Further, a thermoplastic patch 650 is provided onto the patch 640. The thermoplastic patch 650 has a through-hole. A connector wire 661 is provided between the patch 640 and the thermoplastic patch 650 such that the connector wire 661 is exposed by the through-hole. The positioning of the connector wire 661 may be performed by hand or may be performed by a robotic arm or other automated tool.

After positioning the patches and the wire 661, the stack is laminated 604 resulting in the laminated stack 670. Thereby, the connector wire 661 is clamped between the conductive patch 641 and the thermoplastic patch 650.

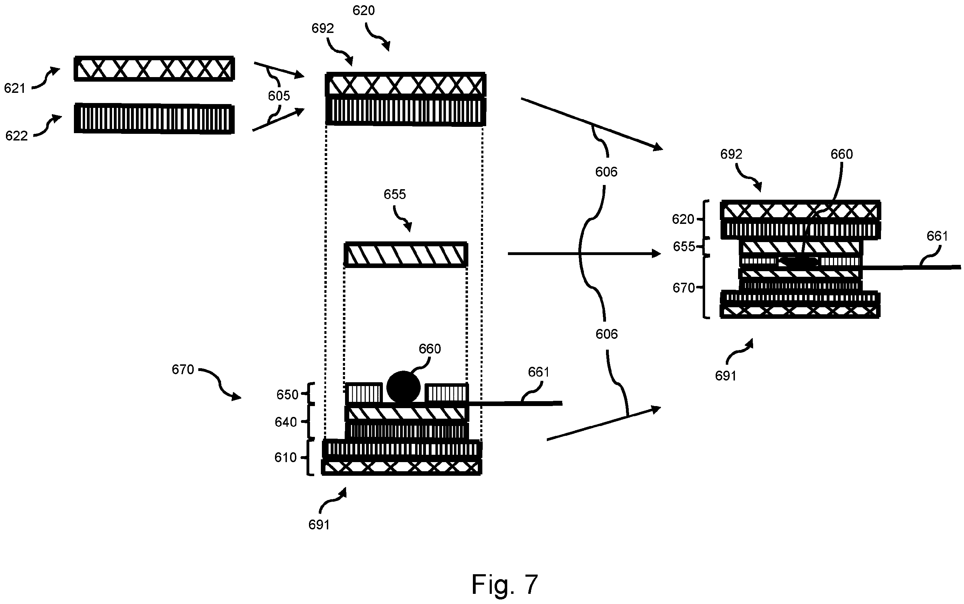

Turning to Figure 7, a conductive resin 660 is then provided within the through-hole of the thermoplastic patch 650. Further, a second conductive patch 655 is provided onto the thermoplastic patch 650, thereby closing off the through-hole with the conductive resin 660 inside. Further, a second outer patch 620 is provided onto the thermoplastic patch 650, against the second conductive patch 655. The second outer patch 620 comprises a second thermoplastic patch 622 laminated to the second textile patch 621. The second outer patch 620 is positioned such that the second textile patch 621 faces a second outer side 692 of the textile connector 6. The second outer textile patch 621 and the second thermoplastic patch 622 are laminated together during step 605, which may be performed in parallel with previous steps 601, 602, 603 and/or 604. Alternatively, pre-laminated second outer patch 620 may be provided, thereby omitting step 605.

After layering all the patches of the textile connector patch, the patches are laminated together in step 606. Step 606 may involve activating the curing of the conductive resin 660. Activation may be achieved by adding a chemical compound. Alternatively, the conductive resin 660 may be activated only by the heat and/or pressure applied during the lamination. After activation, the resin 660 is temporarily deformable, after which it cures and becomes rigid.

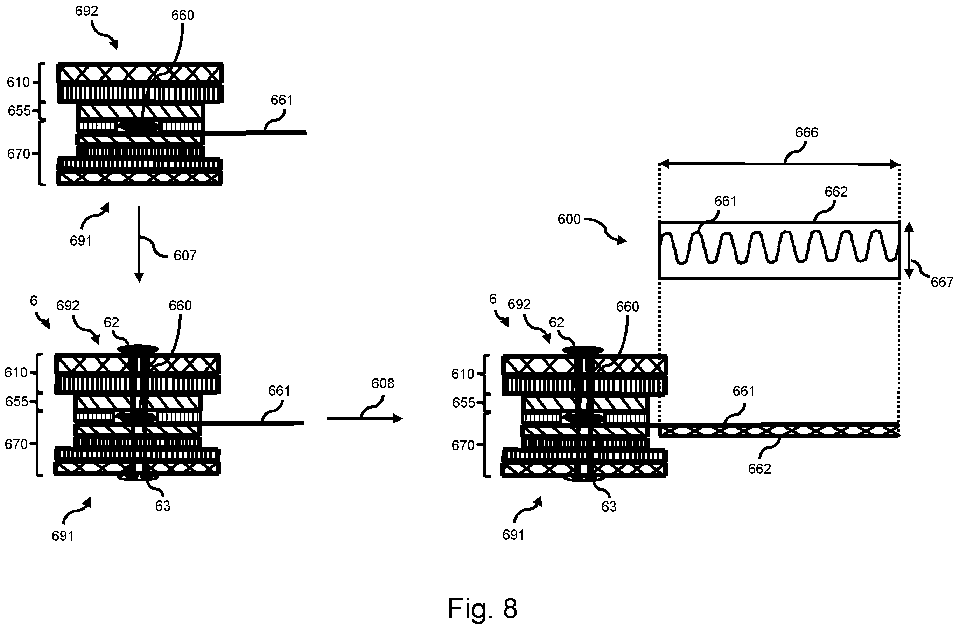

Figure 8 shows a further step 607, wherein a snap fastener 62, 63 is pierced through the textile connector patch, thereby obtaining the textile connector 6. Thereby, a conductive path is provided through the textile connector patch. A permanent conductive connection is obtained between the connector wire 661, the conductive resin 660, the conductive patches 641, 655 and the snap fastener 62, 63. The snap fastener 62, 63 provides access to the conductive path on the outside of the textile connector 6.

In optional step 608, the elongated portion is at least partially provided with a protective sheath 662. The protective sheath 662 may, for example, be made of an electrically isolating material or may be made of textile material. The protective sheath 662 shields the connector wire 661 from external electrical interference. Figure 8 shows a protective sheath 662 made of a strip of fabric 662. Subfigure 600 shows a top view of the protective sheath 662. The connector wire 661 may, for example, be curved into a sinusoidal-like shape along the strip 662. The strip 662 may be a single strip, or may comprise two strips provided on top of each other with the wire 661 in between so as to at least partially enclose the connector wire 661. Such two strips may have an identical size, or may, for example, have the same length 666 and a different width 667 to partially expose the connector wire 661. This allows easy access to the connector wire 661 and visual inspection of the positioning of the connector wire 661. Step 608 may be performed after obtaining the textile connector 6, may be performed before the connector wire 661 is clamped between the laminated stack 670 in step 603, or may be performed during or between any of the manufacturing steps 601-607.

As used in this application, the term "circuitry" may refer to one or more or all of the following: (a) hardware-only circuit implementations (such as implementations in only analog and/or digital circuitry) and (b) combinations of hardware circuits and software, such as (as applicable): (i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions) and (c) hardware circuit(s) and or processor(s), such as a microprocessor(s) or a portion of a microprocessor(s), that requires software (e.g., firmware) for operation, but the software may not be present when it is not needed for operation. This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A method for manufacturing a textile connector patch (2, 5) for a textile connector (3, 6), the method comprising:
- providing a first outer patch (210, 310, 510, 610) comprising a first textile patch (211, 311, 510, 611);
- providing a conductive patch (241, 341, 540, 641) on the first outer patch;
- providing a thermoplastic patch (250, 350, 550, 650) having a through-hole (245, 345) onto the conductive patch;
- providing a connector wire (261, 361, 561, 661) between the conductive patch and the thermoplastic patch such that the connector wire is exposed by the through-hole;
- laminating (500, 603) the first outer patch, the conductive patch and the thermoplastic patch together, thereby forming a laminated stack (270, 370, 570, 670) that clamps the connector wire;
- providing (501) a conductive resin (260, 360, 560, 660) within the through-hole;
- providing (502, 605) a second outer patch (220, 320, 520, 620) comprising a second textile patch (221, 321, 520, 621) onto the thermoplastic patch; and
- laminating (503, 606) the provided patches (210, 241, 250, 220, 310, 341, 350, 320, 510, 540, 550, 520, 610, 641, 650, 620) together to obtain the textile connector patch; wherein, by the laminating, the conductive resin is deformed to provide a permanent connection between the connector wire and the conductive patch.

2. The method according to claim 1, wherein the first outer patch (310) further comprises a first thermoplastic patch (312) laminated to the first textile patch (311), and wherein the first outer patch is positioned such that the first textile patch faces a first outer side (301) of the textile connector patch.

3. The method according to any of the preceding claims, wherein the second outer patch further (320) comprises a second thermoplastic patch (322) laminated to the second textile patch (321), and wherein the second outer patch is positioned such that the second textile patch faces a second outer side (302) of the textile connector patch.

4. The method according to any one of the preceding claims, further comprising providing a further thermoplastic patch (342) between the conductive patch (341) and the first outer patch (310).

5. The method according to claim 4, further comprising laminating the further thermoplastic patch onto the conductive patch.

6. The method according to any one of the preceding claims, further comprising providing a second conductive patch (355) between the laminated stack (370) and the second outer patch (320); and wherein, by the laminating, the permanent connection is further provided with the second conductive patch.

7. The method according to any one of the preceding claims, further comprising activating the conductive resin (260, 360) to allow deformation of the conductive resin during laminating.

8. The method according to any one of the preceding claims, wherein the conductive patch and the thermoplastic patch have equal area dimensions (280, 480, 481), first area dimensions, and wherein the first and second outer patches have equal area dimensions (290, 490, 491), second area dimensions.

9. The method according to claim 8, wherein the second area dimensions are larger than the first area dimensions such that the permanent connection is contained within the first and second outer patches.

10. The method according to any one of the preceding claims, wherein the connector wire extends outwardly from the textile connector patch, thereby defining a clamped portion (263, 363) and an elongated portion (264, 364) of the connector wire.

11. The method according to claim 10, wherein the elongated portion is provided with a protective sheath (262, 362, 662).

12. The method according to claim 11, wherein the protective sheath is made of textile material.

13. The method according to claim 11 or 12, wherein the protective sheath is an electrically isolating material.

14. A method for manufacturing a textile connector comprising:
- manufacturing a textile connector patch according to any one of the preceding claims; and
- piercing a snap fastener (31, 32) through the textile connector patch, thereby providing a conductive path through the textile connector patch via the permanent connection.

15. A textile connector patch (2, 3) for a textile connector, the textile connector patch comprising:
- a first outer patch (210, 310) comprising a first textile patch (211, 311);
- a conductive patch (241, 341) on the first outer patch;
- a thermoplastic patch (250, 350) having a through-hole (245, 345), the thermoplastic patch on the conductive patch;
- a connector wire between the conductive patch and the thermoplastic patch and partially located within the through-hole;
- a conductive resin cured throughout the through-hole, the conductive resin providing a permanent connection between the connector wire and the conductive patch; and
- a second outer patch (220, 320) comprising a second textile patch (221, 321),
wherein the patches are laminated together to form the textile connector patch.
